(19) Europäisches Patentamt
European Patent Office
Office européen des brevets

(11) EP 1 840 654 B1

(12) **EUROPEAN PATENT SPECIFICATION**

(45) Date of publication and mention of the grant of the patent:
**20.03.2013 Bulletin 2013/12**

(51) Int Cl.:
***G03F 7/038*** *(2006.01)* ***G03F 7/033*** *(2006.01)*

(21) Application number: **07105195.7**

(22) Date of filing: **29.03.2007**

(54) **Radiation-sensitive negative resin composition**

Strahlungsempfindliche negative Harzzusammensetzung

Composition de résine négative sensible aux radiations

(84) Designated Contracting States:
**DE IE IT PT**

(30) Priority: **30.03.2006 JP 2006095642**

(43) Date of publication of application:
**03.10.2007 Bulletin 2007/40**

(73) Proprietor: **JSR Corporation**
**Tokyo 104-0045 (JP)**

(72) Inventors:
- **Onimaru, Nami**
  **Chuo-ku**
  **Tokyo 104-0045 (JP)**
- **Sakai, Hiroko**
  **Chuo-ku**
  **Tokyo 104-0045 (JP)**

(74) Representative: **TBK**
**Bavariaring 4-6**
**80336 München (DE)**

(56) References cited:
**EP-A- 1 610 177**
**JP-A- 5 341 521**
**US-A1- 2004 142 280**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 840 654 B1

## Description

### FIELD OF THE INVENTION

The present invention relates to a radiation-sensitive negative resin composition suited for producing platings, a transfer film with the composition, and a process for producing platings using the composition.

### BACKGROUND OF THE INVENTION

The downsizing of electronic devices such as cellular phones has brought rapid transitions to higher densities and more multilayered structures of large scale integration (LSI) chips. Such transitions entail multipin technology which is a technique for mounting LSI chips on electronic devices, and bare chip mounting methods such as tape automated bonding (TAB) and flip chip bonding are increasingly accepted. In the multipin technology, protruded electrodes called bumps should be arranged as connecting terminals with high precision on the LSI chips.

Precision parts such as bumps are produced by precision micromachining, and photo application is the predominant technology. The photo application is a general term for technologies in which a radiation-sensitive resin composition is applied to a workpiece surface to form a film, the film is patterned by photolithography, and the patterned film is used as a mask to produce precision parts by a single or a combination of chemical or electrolytic etching and electroforming technology based on electroplating.

Bumps are usually formed as follows. A wafer is provided on which LSI circuits are formed, and a barrier metal as a conductive layer is provided on the wafer. Thereafter, a radiation-sensitive resin composition, so called resist, is applied on the barrier metal, followed by drying. The composition is irradiated with radiation (hereinafter, also referred to as "exposed") through a mask having apertures corresponding to bumps to be produced. The latent image is developed to produce a pattern and, with the pattern as a template, an electrode material such as gold or copper is deposited by electroplating. The resin is released, and the barrier metal is etched. The wafer is then cut into square chips, followed by packaging such as TAB or mounting such as flip chip bonding.

The bump shapes are diversified, including ball bumps, mushroom bumps and straight bumps.

The present inventors have proposed a radiation-sensitive resin composition suited for photo application (Patent Document 1). The composition enables production of bumps on a substrate such as copper or gold with high precision.

The resist used in the bump production has the following requirements.

(1) The resist forms a film having a uniform thickness.
(2) The resist forms a pattern as a template with nearly perpendicular sidewalls, and the pattern has high fidelity to the size of the apertures of the mask.
(3) The resist has high sensitivity and developability to increase the production efficiency.
(4) The resist has good wettability with a plating solution.
(5) The resist is not dissolved in the plating solution during the plating and does not deteriorate the plating solution.
(6) The resist has high adhesion to the substrate to prevent the plating solution from leaking in between the substrate and the resist.
(7) After plating, the resist is easily released with a releasing solution.

The present inventors have proposed a radiation-sensitive resin composition which is suited for the bump production and shows high adhesion to gold substrates (Patent Document 2).

The recent miniaturization of LSI chips requires that bumps are formed at small pitches and are substantially uniform in height. To produce such bumps at small pitches, plating should be performed at a low current density for a long period of time. However, when the resin film of the above composition is soaked in a plating solution for a long time, the resist pattern is swollen and the plating solution leaks in between the pattern and the substrate. Moreover, the resin film of the above composition shows good photosensitivity and photocurability, but has poor resolution.

Patent Document 3 discloses a photosensitive resin composition that includes an unsaturated linear polymer, an acid anhydride-modified epoxy acrylate compound, a photopolymerizable compound containing two or more terminal ethylene groups, and a photoinitiator, wherein the unsaturated linear polymer is obtained by adding glycidyl (meth) acrylate to a linear polymer which is a copolymer of phenoxypolyethylene glycol (meth)acrylate, benzyl (meth)acrylate, carboxyl group-containing vinyl monomer and other vinyl monomer. However, Patent Document 3 does not disclose or suggest the use and effects of hydroxystyrene.

Patent Document 1: JP-A-2000-39709
Patent Document 2: JP-A-H10-161307
Patent Document 3: JP-A-H05-341521

EP 1610177 (A1) discloses a photosensitive resin film and a cured film made thereof. The uncured photosensitive resin film comprises (A) a specific alkali-soluble copolymer, (B) a compound having at least one ethylenically unsaturated double bond and (C) a radiation-sensitive radical polymerization initiator by the use of which a coating film having a dry film thickness of 70 μm in an uncured state has a 365 nm radiation transmittance of not less than 10% and a 405 nm radiation transmittance of not less than 60%, contains the radiation-sensitive radical polymerization initiator (C) in an amount of 20 to 40 parts by weight based on 100 parts by weight of the component (A), and has a dry film thickness of not less than 50 μm.; According to the photosensitive resin film, a high bump having a height of not less than 50 μm can be readily formed on a chip substrate with high precision though formation of such a high bump is difficult by the conventional technique. Moreover, connection failure of an element can be inhibited, and reliability of an element can be enhanced.

**DISCLOSURE OF THE INVENTION**

It is an object of the present invention to provide a process whereby thick platings such as bumps and wirings are produced with high precision while the resist shows high swelling resistance to the plating solution and the plating solution is prevented from leaking in between the pattern and the substrate. It is another object of the invention to provide a radiation-sensitive negative resin composition that shows high sensitivity in the production process and possesses excellent resolution and heat resistance. It is a further object to provide a transfer film with the composition.

The present inventors studied diligently in view of the above background. As a result, they have developed a radiation-sensitive negative resin composition that includes (A) a polymer including structural units derived from specific monomers, (B) a compound having at least one ethylenically unsaturated double bond, and (C) a specific radiation-sensitive radical polymerization initiator. The composition and a transfer film with the composition enable production of high bumps with high precision. The present invention has been completed based on the findings.

A radiation-sensitive negative resin composition according to the present invention comprises:

(A) a polymer including a structural unit represented by Formula (1) and a structural unit represented by Formula (2);
(B) a compound having at least one ethylenically unsaturated double bond; and
(C) a radiation-sensitive radical polymerization initiator;

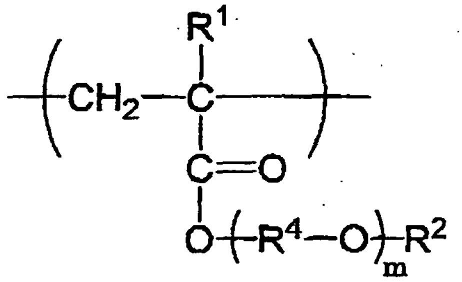

(1)

wherein $R^1$ is a hydrogen atom or a methyl group; $R^2$ is a linear, cyclic or aromatic hydrocarbon group of 6 to 12 carbon atoms, or a substituted hydrocarbon group wherein at least one hydrogen atom in the linear, cyclic or aromatic hydrocarbon group is substituted with a hydrocarbon group; $R^4$ is $-(C_nH_{2n})-$; m is an integer of 1 to 10; and n is an integer of 2 to 4;

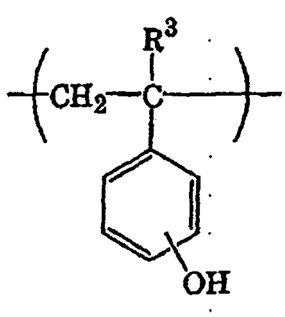

(2)

wherein $R^3$ is a hydrogen atom or a methyl group; and wherein

the radiation-sensitive radical polymerization initiator (C) includes a biimidazole compound represented by Formula (3):

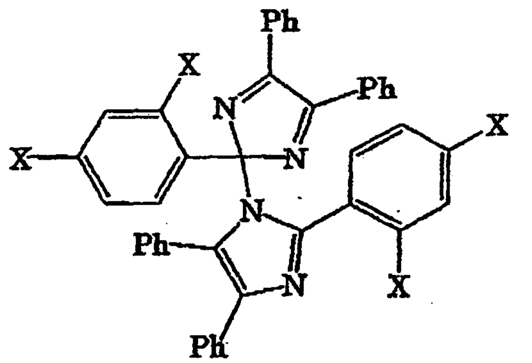

(3)

wherein X are each individually a hydrogen atom, a methyl group or a chlorine atom; and Ph is a phenyl group.

The radiation-sensitive negative resin composition is suitably used for producing platings, and is particularly suited for producing bumps.

The radiation-sensitive negative resin composition preferably contains the compound (B) in an amount of 30 to 80 parts by weight based on 100 parts by weight of the polymer (A). The radiation-sensitive negative resin composition preferably contains the radiation-sensitive radical polymerization initiator (C) in an amount of 1 to 40 parts by weight based on 100 parts by weight of the polymer (A). The radiation-sensitive negative resin composition preferably includes an organic solvent (D).

A transfer film according to the present invention comprises a support film and a resin film on the support film, the resin film comprising the radiation-sensitive negative resin composition.

A process for producing platings according to the present invention comprises the steps of:

(1) providing a resin film on a wafer having a barrier metal layer, the resin film comprising the radiation-sensitive negative resin composition;
(2) exposing the resin film to light and developing a latent image to form a pattern;
(3) depositing an electrode material by electroplating using the pattern as a template; and
(4) releasing the remaining resin film and etching the barrier metal layer.

The radiation-sensitive negative resin composition of the invention has excellent resolution, adhesion and heat resistance and can form a good pattern configuration on a substrate. The pattern increases the cure degree by heating. Consequently, the composition facilitates high-precision production of bumps on chips. The resist pattern is not swollen by prolonged soaking in the plating solution. Consequently, the plating treatment may be performed over a long period of time and bumps substantially uniform in height may be produced. The radiation-sensitive negative resin composition can cope with finer bumps for miniaturization of LSI chips.

## PREFERRED EMBODIMENTS OF THE INVENTION

The present invention will be described below.

The radiation-sensitive negative resin composition according to the present invention includes:

(A) a polymer including a structural unit represented by Formula (1) and a structural unit represented by Formula (2);
(B) a compound having at least one ethylenically unsaturated double bond; and
(C) a radiation-sensitive radical polymerization initiator represented by formula (3).

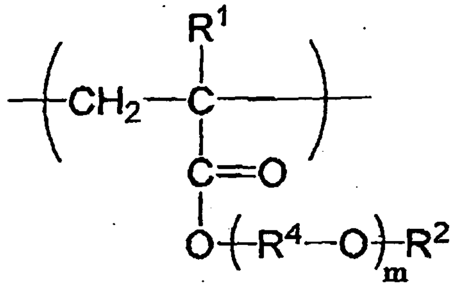

(1)

In Formula (1), $R^1$ is a hydrogen atom or a methyl group; $R^2$ is a linear, cyclic or aromatic hydrocarbon group of 6 to 12 carbon atoms, or a substituted hydrocarbon group wherein at least one hydrogen atom in the linear, cyclic or aromatic hydrocarbon group is substituted with a hydrocarbon group; $R^4$ is $-(C_nH_{2n})-$; m is an integer of 1 to 10; and n is an integer of 2 to 4.

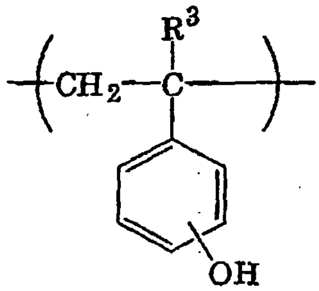

(2)

In Formula (2), $R^3$ is a hydrogen atom or a methyl group.
These components are discussed below.

(Polymer (A))

The polymer (A) includes a structural unit represented by Formula (1) and a structural unit represented by Formula (2).
With the polymer (A) including the structural unit of Formula (1), the obtainable resist shows high adhesion to a substrate during plating and prevents a plating solution from leaking in between the resist and the substrate during the prolonged plating.
The polymer (A) generally contains the structural units of Formula (1) in an amount of 1 to 40% by weight, preferably 10 to 30% by weight. This amount of the structural units of Formula (1) ensures a sufficient molecular weight of the polymer (A) and the obtainable resin film is resistant to swelling by the plating solution.

(Monomer (1'))

The structure represented by Formula (1) may be obtained by using a monomer (1') represented by the following formula in the polymerization of the polymer (A):

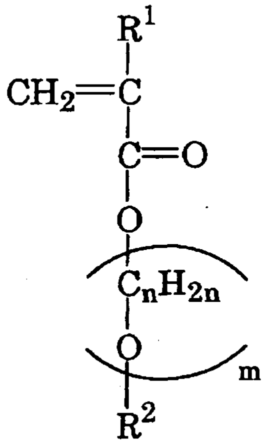

(1')

wherein $R^1$, $R^2$, m and n are as defined in Formula (1).

Examples of the linear hydrocarbon groups of 6 to 12 carbon atoms include hexyl, heptyl, octyl and nonyl.

Examples of the cyclic hydrocarbon groups of 6 to 12 carbon atoms include cycloalkyl groups such as cyclohexyl, cycloheptyl and cyclooctyl; and groups derived from bridge-containing hydrocarbons, such as adamantane, bicyclo [2.2.1] heptane, tetracyclo[6.2.1.1$^{3,6}$.0$^{2,7}$]dodecane and tricyclo[5.2.1.0$^{2,6}$]decane.

Examples of the aromatic hydrocarbon groups of 6 to 12 carbon atoms include phenyl, o-tolyl, m-tolyl, p-tolyl, 4-t-butylphenyl, 1-naphthyl and benzyl.

In the linear, cyclic and aromatic hydrocarbon groups, one or more hydrogen atoms may be substituted with a hydrocarbon group such as methyl or ethyl.

Examples of the monomers (1') include phenoxydiethylene glycol (meth)acrylate, phenoxytriethylene glycol (meth)acrylate, phenoxytetraethylene glycol (meth)acrylate, phenoxydipropylene glycol (meth)acrylate, phenoxytripropylene glycol (meth)acrylate, phenoxytetrapropylene glycol (meth)acrylate, lauroxydiethylene glycol (meth)acrylate, lauroxytriethylene glycol (meth)acrylate, lauroxytetraethylene glycol (meth)acrylate, lauroxydipropylene glycol (meth)acrylate, lauroxytripropylene glycol (meth)acrylate and lauroxytetrapropylene glycol (meth)acrylate.

Of the monomers (1'), phenoxydiethylene glycol (meth)acrylate, phenoxytriethylene glycol (meth)acrylate, phenoxytetraethylene glycol (meth)acrylate, phenoxydipropylene glycol (meth)acrylate, phenoxytripropylene glycol (meth) acrylate and phenoxytetrapropylene glycol (meth)acrylate are preferable, and phenoxydiethylene glycol acrylate, phenoxytriethylene glycol acrylate and phenoxytetraethylene glycol acrylate are more preferable because the obtainable radiation-sensitive negative resin composition shows high adhesion to substrates, heat resistance and resistance to the prolonged plating.

The monomers (1') may be used singly or in combination of two or more kinds.

With the polymer (A) including the structural unit of Formula (2), the obtainable resist shows resistance to swelling during the plating and is not lifted or released. Consequently, the resist prevents more effectively the plating solution from leaking in between the resist and the substrate during the prolonged plating. Furthermore, the structural unit of Formula (2) suppresses the crosslink density of the cured film, leading to good resolution.

The polymer (A) generally contains the structural units of Formula (2) in an amount of 1 to 30% by weight, preferably 10 to 20% by weight. This amount of the structural units of Formula (2) ensures a sufficient molecular weight of the polymer (A) and the obtainable resin film is resistant to swelling by the plating solution.

(Monomer (2'))

The structure represented by Formula (2) may be obtained by using a hydroxyl-containing aromatic vinyl compound (hereinafter, monomer (2')) in the polymerization of the polymer (A). Examples of the monomers (2') include o-hydroxystyrene, p-hydroxystyrene, m-hydroxystyrene and p-isopropenylphenol.

Of the monomers (2'), p-hydroxystyrene and p-isopropenylphenol are preferable, and p-isopropenylphenol is more preferable because the obtainable radiation-sensitive resin composition shows high resistance to the prolonged plating.

The monomers (2') may be used singly or in combination of two or more kinds.

(Monomer (I))

The polymer (A) may contain a structural unit derived from a monomer (hereinafter, monomer (I)) copolymerizable with the monomers (1') and (2').
Examples of the monomers (I) include:

aromatic vinyl compounds such as styrene, α -methylstyrene, p-methylstyrene and p-methoxystyrene;
heteroatom-containing alicyclic vinyl compounds such as N-vinylpyrrolidone and N-vinylcaprolactam;
cyano group-containing vinyl compounds such as acrylonitrile and methacrylonitrile;
conjugated diolefins such as 1,3-butadiene and isoprene;
carboxyl group-containing vinyl compounds such as acrylic acid and methacrylic acid;
(meth)acrylates such as methyl (meth)acrylate, ethyl (meth)acrylate, n-propyl (meth)acrylate, n-butyl (meth)acrylate, 2-hydroxyethyl (meth)acrylate, 2-hydroxypropyl (meth)acrylate, polyethylene glycol mono (meth) acrylate, polypropylene glycol mono (meth) acrylate, glycerol mono(meth)acrylate, phenyl (meth)acrylate, benzyl (meth)acrylate, cyclohexyl (meth)acrylate, isobornyl (meth)acrylate and tricyclodecanyl (meth)acrylate; and
p-hydroxyphenyl (meth)acrylamide.

Of the monomers (I), styrene, acrylic acid, methacrylic acid, methyl (meth)acrylate, ethyl (meth)acrylate, n-butyl (meth)acrylate, tricyclodecanyl (meth)acrylate, benzyl (meth) acrylate, isobornyl (meth) acrylate and p-hydroxyphenyl (meth)acrylamide are preferred.
The monomers (I) may be used singly or in combination of two or more kinds.
The polymer (A) may be produced by radical polymerization. Examples of the polymerization methods include emulsion polymerization, suspension polymerization, solution polymerization and bulk polymerization, with the solution polymerization being particularly preferable.

(Polymerization initiator)

A usual radical polymerization initiator may be used in the production of the polymer (A).
Examples of the polymerization initiators include:

azo compounds such as 2,2'-azobisisobutyronitrile, 2,2'-azobis-(2,4-dimethylvaleronitrile), 2,2'-azobis-(4-methoxy-2,4-dimethylvaleronitrile), 2,2'-azobis-(2-methylbutyronitrile), 1,1'-azobis-(cyclohexane-1-carbonitrile) and dimethyl-2,2'-azobis(2-methylpropionate);
organic peroxides such as benzoyl peroxide, lauroyl peroxide, tert-butylperoxy pivalate and 1,1'-bis-(tert-butylperoxy) cyclohexane; and
hydrogen peroxide.

The organic peroxides may be used in combination with reducing agents as redox polymerization initiators.

(Polymerization solvent)

The solvents for use in the solution polymerization for the polymer (A) are not particularly limited as long as they do not react with the monomers and can dissolve the polymer formed.
Examples of the solvents include:

alcohols such as methanol, ethanol, ethylene glycol, diethylene glycol and propylene glycol;
cyclic ethers such as tetrahydrofuran and dioxane;
alkyl ethers of polyhydric alcohols, such as ethylene glycol monomethyl ether, ethylene glycol monoethyl ether, ethylene glycol dimethyl ether, ethylene glycol diethyl ether, diethylene glycol monomethyl ether, diethylene glycol monoethyl ether, diethylene glycol dimethyl ether, diethylene glycol diethyl ether, diethylene glycol ethyl methyl ether, propylene glycol monomethyl ether and propylene glycol monoethyl ether;
alkyl ether acetates of polyhydric alcohols, such as ethylene glycol monoethyl ether acetate, diethylene glycol ethyl ether acetate, propylene glycol ethyl ether acetate and propylene glycol monomethyl ether acetate;
aromatic hydrocarbons such as toluene and xylene;
ketones such as acetone, methyl ethyl ketone, methyl isobutyl ketone, cyclohexanone, 4-hydroxy-4-methyl-2-pentanone and diacetone alcohol; and
esters such as ethyl acetate, butyl acetate, ethyl 2-hydroxypropionate, ethyl 2-hydroxy-2-methylpropionate, ethyl 2-hydroxy-2-methylpropionate, ethyl ethoxyacetate, ethyl hydroxyacetate, methyl 2-hydroxy-3-methylbutanoate,

methyl 3-methoxypropionate, ethyl 3-methoxypropionate, ethyl 3-ethoxypropionate, methyl 3-ethoxypropionate and ethyl lactate.

Of these, the cyclic ethers, the alkyl ethers of polyhydric alcohols, the alkyl ether acetates of polyhydric alcohols, the ketones and the esters are preferred.

The polymer (A) obtained by the radical copolymerization generally has a polystyrene equivalent weight-average molecular weight (Mw) of 1,000 to 100,000, preferably 2,000 to 50,000, more preferably 3,000 to 20,000, as determined by gel permeation chromatography.

(Compound (B) having at least one ethylenically unsaturated double bond)

The compound (B) has at least one ethylenically unsaturated group in the molecule and is liquid or solid at room temperature. Examples of the preferred compounds (B) include (meth) acrylate compounds having (meth) acryloyl groups, and compounds having vinyl groups. The (meth)acrylate compounds may be monofunctional or polyfunctional.

Examples of the monofunctional (meth) acrylate compounds include 2-hydroxyethyl (meth)acrylate, 2-hydroxypropyl (meth)acrylate, 2-hydroxybutyl (meth)acrylate, methyl (meth) acrylate, ethyl (meth) acrylate, propyl (meth)acrylate, isopropyl (meth)acrylate, butyl (meth)acrylate, isobutyl (meth)acrylate, tert-butyl (meth)acrylate, pentyl (meth) acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth) acrylate, dodecylamyl (meth)acrylate, lauryl (meth)acrylate, octadecyl (meth)acrylate, stearyl (meth)acrylate, tetrahydrofurfuryl (meth)acrylate, butoxyethyl (meth) acrylate, ethoxydiethylene glycol (meth)acrylate, benzyl (meth)acrylate, cyclohexyl (meth)acrylate, phenoxyethyl (meth)acrylate, polyethylene glycol mono(meth)acrylate, polypropylene glycol mono(meth)acrylate, methoxyethylene glycol (meth)acrylate, ethoxyethyl (meth)acrylate, methoxypolyethylene glycol (meth)acrylate, phenoxypolyethylene glycol (meth)acrylate, phenoxypolypropylene glycol (meth)acrylate, methoxypolypropylene glycol (meth)acrylate, tricyclo[5.2.1.0$^{2,6}$]decadienyl (meth) acrylate, tricyclo[5.2.1.0$^{2,6}$]decanyl (meth)acrylate, tricyclo[5.2.1.0$^{2,6}$]decenyl (meth)acrylate, isobornyl (meth)acrylate, bornyl (meth)acrylate, diacetone (meth)acrylamide, isobutoxymethyl (meth)acrylamide, N-vinylpyrrolidone, N-vinylcaprolactam, N,N-dimethyl (meth)acrylamide, tert-octyl (meth)acrylamide, dimethylaminoethyl (meth)acrylate, diethylaminoethyl (meth)acrylate, 7-amino-3,7-dimethyloctyl (meth)acrylate, dimethyl maleate, diethyl maleate, dimethyl fumarate, diethyl fumarate, ethylene glycol monomethyl ether (meth)acrylate, ethylene glycol monoethyl ether (meth)acrylate, glycerol (meth) acrylate, acrylic acid amide, methacrylic acid amide and (meth)acrylonitrile.

Examples of the polyfunctional (meth) acrylate compounds include trimethylolpropane tri(meth)acrylate, ethylene glycol di(meth)acrylate, tetraethylene glycol di(meth)acrylate, polyethylene glycol di(meth)acrylate, 1,4-butanediol di(meth)acrylate, butylene glycol di(meth)acrylate, propylene glycol di(meth)acrylate, trimethylolpropane di(meth)acrylate, 1,6-hexanediol di(meth)acrylate, neopentyl glycol di(meth)acrylate, tris(2-hydroxyethyl)isocyanurate tri(meth)acrylate, tris(2-hydroxyethyl)isocyanurate di(meth)acrylate, tricyclodecanedimethanol di(meth)acrylate, epoxy (meth)acrylate obtained by adding (meth)acrylic acid to diglycidyl ether of bisphenol A, bisphenol A-di(meth)acryloyloxyethyl ether, bisphenol A-di(meth)acryloyloxy ethyloxy ethyl ether, bisphenol A-di(meth)acryloyloxy methyl ethyl ether, tetramethylolpropane tetra(meth)acrylate, pentaerythritol tri(meth)acrylate, pentaerythritol tetra(meth)acrylate, dipentaerythritol penta(meth)acrylate and dipentaerythritol hexa(meth)acrylate.

Commercially available compounds may be used as the ethylenically unsaturated compounds (B). Examples thereof include compounds commercially available under the trade names of ARONIX series M-210, M-309, M-310, M-400, M-7100, M-8030, M-8060, M-8100, M-9050, M-240, M-245, M-6100, M-6200, M-6250, M-6300, M-6400 and M-6500 (manufactured by Toagosei Co., Ltd.); KAYARAD series R-551, R-712, TMPTA, HDDA, TPGDA, PEG400DA, MANDA, HX-220, HX-620, R-604, DPCA-20, DPCA-30, DPCA-60 and DPCA-120 (manufactured by Nippon Kayaku Co., Ltd.); and BISCOAT series Nos. 295, 300, 260, 312, 335HP, 360, GPT, 3PA and 400 (manufactured by Osaka Organic Chemical Industry Ltd.).

These compounds (B) may be used singly or in combination of two or more kinds.

The amount of the compounds (B) is usually 30 to 80 parts by weight, preferably 40 to 70 parts by weight based on 100 parts by weight of the alkali-soluble polymer (A). This amount of the compounds (B) leads to good photosensitivity of the obtainable radiation-sensitive resin film, high compatibility with the polymer (A), and improved storage stability of the composition.

(Radiation-sensitive radical polymerization initiator (C))

The radiation-sensitive radical polymerization initiator (C) generates radicals when irradiated with radiation to induce the radical polymerization of the ethylenically unsaturated compound (B).

The radiation used herein refers to ultraviolet light, visible light, far ultraviolet light, X-ray, electron beams and

the like. A mercury lamp is a usual radiation source for the curing of radiation-sensitive resins. In the spectral lines emitted from the mercury lamp, the i-line (365 nm) and the h-line (405 nm) are generally used for the curing of radiation-sensitive resins.

The i-line has high energy and can cure the material to a high degree without the curing being prevented by oxygen. However, this short-wavelength light is strongly absorbed. Consequently, when the i-line is used in the curing of a thick radiation-sensitive resin film, sufficient energy cannot reach the depth of the resin film, failing to produce a desired pattern in the film. As a result, the resist protrusions are not rectangular in cross section or have a trapezoidal cross section tapering from the surface toward the bottom.

The h-line has lower energy than the i-line and takes a long time to cure the material. Accordingly, it is more likely that oxygen inhibits the curing of the surface of the radiation-sensitive resin film, resulting in drastically reduced resolution. However, because the h-line has a longer wavelength than the i-line, more light will be transmitted through the film. Consequently, when the h-line is used in the curing of a thick radiation-sensitive resin film, sufficient energy will reach the depth of the resin film and will produce a desired pattern rectangular in cross section.

With the above characteristics of the i-line and the h-line, the radiation-sensitive negative resin composition of the invention preferably satisfies the following requirements.

A resin film of the composition having a thickness such that the dry thickness will be 70 μm preferably has:

(1) a transmission of the i-line (365 nm) of not less than 10%, more preferably 12 to 30%; and
(2) a transmission of the h-line (405 nm) of not less than 60%, more preferably 65 to 80%.

When these requirements are satisfied, the radiation-sensitive resin film may produce a desired high-precision pattern that is cured thoroughly from the surface to the bottom.

For example, the radiation-sensitive resin composition having the above properties may form a film 5 to 200 μm in thickness on the substrate and may be irradiated with the i-line and the h-line. The resultant pattern has high precision and is cured thoroughly from the surface to the bottom.

As described above, the radiation-sensitive resin composition permits increased transmissions of the above wavelengths. Consequently, the light can be transmitted from the surface to the inside of the radiation-sensitive resin film with little decay, and the resin film is thoroughly and uniformly cured. The patterned film has a cross section in which the sidewalls are substantially perpendicular to the bottom. Such pattern enables high-precision deposition of thick and straight bumps.

The radiation transmission may be determined as follows.

The composition containing the specific amounts of the components (A), (B) and (C) is dissolved in ethyl lactate in a concentration of 65% by weight. The ethyl lactate solution is spread on a 1 mm thick quartz substrate by spin coating. The resultant resin film is baked on a hot plate at 120°C for 5 minutes to evaporate the solvent. The rotation in the spin coating is controlled such that the baked film will have a thickness of 70 μm.

The transmission of wavelengths from 300 nm to 500 nm through the resin film on the quartz substrate is measured with a spectrophotometer (e.g., HITACHI Spectrophotometer U-2010). As a reference, the transmission of these wavelengths through the quartz substrate without the resin film is measured.

The absorbance in terms of absorptivity coefficient is preferably as follows.

An uncured resin film of the composition having a thickness such that the dry thickness will be 70 μm preferably has:

(1) an absorptivity coefficient of the 365 nm radiation of not more than 15,000 $m^{-1}$; and
(2) an absorptivity coefficient of the 405 nm radiation of not more than 4,000 $m^{-1}$.

The absorptivity coefficient ε may be determined by the formula:

$$\varepsilon=\log(I_0/I)/L$$

wherein ε is absorptivity coefficient ($m^{-1}$), I is intensity (cd) of light measured immediately after the light is transmitted through the resin film, $I_0$ is intensity (cd) of light measured before the light is transmitted through the resin film, and L is dry thickness (m) of the resin film.

This absorptivity coefficient may be achieved by selecting the type and amount of the radiation-sensitive radical polymerization initiator (C). The amount of the radiation-sensitive radical polymerization initiator (C) is usually 1 to 40 parts by weight, preferably 5 to 30 parts by weight, more preferably 10 to 20 parts by weight based on 100 parts by weight of the polymer (A).

The radiation-sensitive radical polymerization initiator (C) for achieving the above absorptivity coefficient is a biimidazole compound represented by Formula (3):

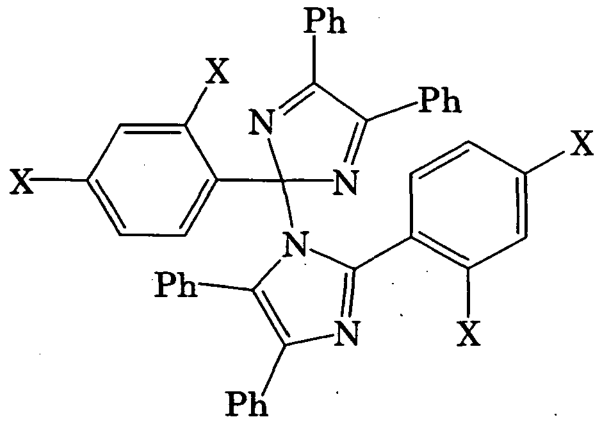

(3)

wherein X are each individually a hydrogen atom, a methyl group or a chlorine atom; and Ph is a phenyl group.

Examples of the biimidazole compounds include
2,2'-bis(2,4-dichlorophenyl)-4,5,4',5'-tetraphenyl-1,2'-biimidazole,
2,2'-bis(2-chlorophenyl)-4,5,4',5'-tetraphenyl-1,2'-biimidazole,
2,2'-bis(2,4-dichlorophenyl)-4,5,4',5'-tetraphenyl-1,2'-biimidazole,
2,2'-bis(2,4-dimethylphenyl)-4,5,4',5'-tetraphenyl-1,2'-biimidazole,
2,2'-bis(2-methylphenyl)-4,5,4',5'-tetraphenyl-1,2'-biimid azole and
2,2'-diphenyl-4,5,4',5'-tetraphenyl-1,2'-biimidazole.
These compounds may be used singly or in combination of two or more kinds.

The amount of the biimidazole compounds is usually 1 to 30 parts by weight, preferably 1 to 20 parts by weight, more preferably 1 to 10 parts by weight based on 100 parts by weight of the polymer (A). When the amount of the biimidazole compounds is in this range, the obtainable radiation-sensitive resin film shows good photosensitivity and the radiation is transmitted to the inside of the film, resulting in a pattern of straight resist protrusions without tapering.

In the invention, the radiation-sensitive radical polymerization initiator (C) may be a combination of the biimidazole compounds and other radiation-sensitive radical polymerization initiators. Examples of such radiation-sensitive radical polymerization initiators include 2,2-dimethoxy-1,2-diphenylethane-1-one, 4,4'-bis(diethylamino)benzophenone, 2-benzyl-2-dimethylamino-1-(4-morpholinophenyl)-butanone-1 and
2-methyl-1-[4-(methylthio)phenyl]-2-morpholinopropanone-1. Commercially available compounds such as IRGACURE 369 and IRGACURE 907 (manufactured by Ciba Specialty Chemicals) are also employable. These compounds may be used singly or in combination of two or more kinds.

(Organic solvent (D))

The resin composition may contain an organic solvent as required. The organic solvents (D) are capable of uniformly dissolving the polymer (A) and other components and are inactive with the components. Examples of the organic solvents include the polymerization solvents used in the production of the polymer (A). High-boiling solvents are also employable, with examples including N-methylformamide, N,N-dimethylformamide, N-methylformanilide, N-methylacetamide, N,N-dimethylacetamide, N-methylpyrrolidone, dimethylsulfoxide, benzyl ethyl ether, dihexyl ether, acetonylacetone, isophorone, caproic acid, caprylic acid, 1-octanol, 1-nonanol, benzyl alcohol, benzyl acetate, ethyl benzoate, diethyl oxalate, diethyl maleate, $\gamma$-butyrolactone, ethylene carbonate, propylene carbonate and phenyl cellosolve acetate.

Of the solvents, the following are suitable from the viewpoints of solvent properties, reactivity with the components and film formability:

- the alkylethers of polyhydric alcohols, such as ethylene glycol monoethyl ether and diethylene glycol monomethyl ether;
- the alkyl ether acetates of polyhydric alcohols, such as ethylene glycol monoethyl ether acetate and propylene glycol monomethyl ether acetate;
- the esters such as ethyl 3-ethoxypropionate, methyl 3-methoxypropionate, ethyl 2-hydroxypropionate and ethyl lactate; and

the ketones such as diacetone alcohol.

The solvents may be used singly or in combination of two or more kinds. The amount of the solvents may be determined appropriately depending on the purpose and application method.

(Other components)

The radiation-sensitive negative resin composition of the invention may contain thermal polymerization inhibitors, surfactants, adhesion improvers and other additives as required.

(Thermal polymerization inhibitors)

The radiation-sensitive resin composition may contain a thermal polymerization inhibitor. Examples of the thermal polymerization inhibitors include pyrogallol, benzoquinone, hydroquinone, methylene blue, tert-butylcatechol, monobenzyl ether, methylhydroquinone, amylquinone, amyloxyhydroquinone, n-butylphenol, phenol, hydroquinone monopropylether, 4,4'-(1-methylethylidene)bis(2-methylphenol), 4,4'-(1-methylethylidene)bis(2,6-dimethylphenol), 4,4'-[1-[4-(1-(4-hydroxyphenyl)-1-methylethyl)phenyl] ethylidene]bisphenol, 4,4',4"-ethylidene tris(2-methylphenol), 4,4', 4"-ethylidene trisphenol and 1,1,3-tris(2,5-dimethyl-4-hydroxyphenyl)-3-phenylpropane. The amount of the thermal polymerization inhibitors is preferably not more than 5 parts by weight based on 100 parts by weight of the polymer (A).

(Surfactants)

The radiation-sensitive resin composition may contain a surfactant in order to improve application, antifoaming and leveling properties.

Commercially available compounds may be used as the surfactants, with examples including FTX-204D, FTX-208D, FTX-212D, FTX-216D, FTX-218, FTX-220D and FTX-222D (manufactured by NEOS); BM-1000 and BM-1100 (manufactured by BM Chemie); MEGAFACE series F142D, F172, F173 and F183 (manufactured by Dainippon Ink and Chemicals, Incorporated); FLUORAD series FC-135, FC-170C, FC-430 and FC-431 (manufactured by Sumitomo 3M); SURFLON series S-112, S-113, S-131, S-141 and S-145 (manufactured by Asahi Glass Co., Ltd.); and SH-28PA, SH-190, SH-193, SZ-6032 and SF-8428 (manufactured by Toray Dow Corning Silicone Co., Ltd.). Of these, FTX-216D, FTX-218 and FTX-220D are preferred.

The amount of the surfactants is preferably not more than 5 parts by weight based on 100 parts by weight of the polymer (A).

(Adhesion improvers)

The radiation-sensitive resin composition may contain an adhesion improver to enhance the adhesion to the substrate. Functional silane coupling agents are suitable adhesion improvers.

The functional silane coupling agents refer to silane coupling agents that have a reactive substituent such as carboxyl, methacryloyl, isocyanate or epoxy group.

Examples of the functional silane coupling agents include trimethoxysilyl benzoic acid, γ-methacryloxypropyltrimethoxysilane, vinyltriacetoxysilane, vinyltrimethoxysilane, γ-isocyanatopropyltriethoxysilane, γ -glycidoxypropyltrimethoxysilane and β -(3,4-epoxycyclohexyl)ethyltrimethoxysilane.

The amount of the adhesion improvers is preferably not more than 20 parts by weight based on 100 parts by weight of the polymer (A).

(Other additives)

For the purpose of fine adjustment of the solubility in alkaline developers, the radiation-sensitive resin composition may contain the following additives:

monocarboxylic acids such as acetic acid, propionic acid, n-butyric acid, iso-butyric acid, n-valeric acid, iso-valeric acid, benzoic acid and cinnamic acid;

hydroxymonocarboxylic acids such as lactic acid, 2-hydroxybutyric acid, 3-hydroxybutyric acid, salicylic acid, m-hydroxybenzoic acid, p-hydroxybenzoic acid, 2-hydroxycinnamic acid, 3-hydroxycinnamic acid, 4-hydroxycinnamic acid, 5-hydroxyisophthalic acid and syringinic acid;

polyvalent carboxylic acids such as oxalic acid, succinic acid, glutaric acid, adipic acid, maleic acid, itaconic acid, hexahydrophthalic acid, phthalic acid, isophthalic acid, terephthalic acid, 1,2-cyclohexanedicarboxylic acid, 1,2,4-cyclohexanetricarboxylic acid, trimellitic acid, pyromellitic acid, cyclopentanetetracarboxylic acid, butanetetracarboxylic acid and 1,2,5,8-naphthalenetetracarboxylic acid; and
acid anhydrides such as itaconic anhydride, succinic anhydride, citraconic anhydride, dodecenylsuccinic anhydride, tricarbanilic anhydride, maleic anhydride, hexahydrophthalic anhydride, methyltetrahydrophthalic anhydride, himic anhydride, 1,2,3,4-butanetetracarboxylic dianhydride, cyclopentanetetracarboxylic dianhydride, phthalic anhydride, pyromellitic anhydride, trimellitic anhydride, benzophenonetetracarboxylic anhydride, ethylene glycol bis(trimellitate anhydride) and glycerin tris(trimellitate anhydride).

The radiation-sensitive resin composition may contain fillers, colorants and viscosity modifiers as required.
Examples of the fillers include silica, alumina, talc, bentonite, zirconium silicate and glass powder. Examples of the colorants include extender pigments such as alumina white, clay, barium carbonate and barium sulfate; inorganic pigments such as zinc oxide, white lead, chrome yellow, red lead oxide, ultramarine, iron blue, titanium oxide, zinc chromate, red oxide and carbon blacks; organic pigments such as brilliant carmine 6B, permanent red 6B, permanent red R, benzidine yellow, phthalocyanine blue and phthalocyanine green; basic dyes such as magenta and Rhodamine; direct dyes such as Direct Scarlet and Direct Orange; and acid dyes such as rhocerin and metanil yellow.
Examples of the viscosity modifiers include bentonite, silica gel and aluminum powder.
These additives are used while still achieving the objects of the present invention. Preferably, the amount of the additives is not more than 50% by weight based on 100% by weight of the components (A), (B) and (C) combined.
The film of the radiation-sensitive resin composition of the invention has improved wettability with developers and plating solutions. Consequently, thick platings such as bumps and wirings are formed with improved precision, and plating failures are prevented. Therefore, the radiation-sensitive resin composition is suitably used for producing platings such as bumps and wirings of integrated circuit elements. Furthermore, the resin composition endures the prolonged plating treatment to enable the production of bumps that are substantially uniform in height. The radiation-sensitive negative resin composition can cope with finer bumps for miniaturization of LSI chips.
The process for producing platings according to the present invention includes the steps of:

(1) providing a resin film on a wafer having a barrier metal layer, the resin film comprising the radiation-sensitive negative resin composition;
(2) exposing the resin film to light and developing a latent image to form a pattern;
(3) depositing an electrode material by electroplating using the pattern as a template; and
(4) releasing the remaining resin film and etching the barrier metal layer.

The resin film in the step (1) may be provided on the wafer by applying the resin composition on the wafer and drying the coating. Alternatively, the resin film may be transferred on the wafer by using the transfer film of the invention described below.
The transfer film according to the present invention includes a support film and a resin film on the support film. The resin film comprises the radiation-sensitive negative resin composition. The transfer film may be manufactured by applying the composition on the support film, followed by drying. The application methods include spin coating, roll coating, screen printing and use of an applicator. The materials of the support films are not particularly limited as long as they have strength enough to endure stress during the fabrication and use of the transfer film.
The resin film of the transfer film may be preferably 5 to 200 μm in thickness.
Releasing the support film from the transfer film affords a radiation-sensitive negative resin film. Like the resin composition described above, this resin film may be used for producing platings.
In the step (2), the latent image is developed using an alkaline developer. The alkaline developer may be a solution of one or more alkaline compounds in water or an appropriate solvent. The development with the alkaline developer is usually followed by washing with water.

## EXAMPLES

Hereinbelow, the present invention will be described by Examples without limiting the invention.

[Synthetic Example 1]

<Synthesis of polymer A1>

A flask purged with nitrogen and equipped with a dry ice/methanol reflux condenser was charged with 5.0 g of 2,2'-azobisisobutyronitrile and 150 g of ethyl lactate, and the polymerization initiator was dissolved by stirring. To the solution were added methacrylic acid (10 g), p-isopropenylphenol (15 g), isobornyl acrylate (40 g), n-butyl acrylate (5

g), tricyclo(5.2.1.0$^{2,6}$)decanyl methacrylate (15 g) and phenoxytripropylene glycol acrylate (15 g). They were stirred gently and were heated to 80°C, and the polymerization was performed at 80°C for 6 hours.

[Synthetic Examples 2-14]

<Synthesis of polymers A2-A9 and comparative polymers CA1-CA4>

Polymers A2 to A9 and comparative polymers CA1 to CA4 were synthesized in the same manner as in Synthetic Example 1, except that the types and amounts of the compounds were altered as shown in Table 1.

<Synthesis of polymer A10>

A flask purged with nitrogen and equipped with a dry ice/methanol reflux condenser was charged with 5.0 g of 2,2'-azobisisobutyronitrile and 150 g of propylene glycol monomethyl ether acetate (PGMEA), and the polymerization initiator was dissolved by stirring. To the solution were added methacrylic acid (10 g), p-isopropenylphenol (15 g), isobornyl acrylate (40 g), n-butyl acrylate (5 g), tricyclo(5.2.1.0$^{2,6}$)decanyl methacrylate (15 g) and phenoxytripropylene glycol acrylate (15 g). They were stirred gently and were heated to 80°C, and the polymerization was performed at 80°C for 6 hours.

Table 1

| Copolymer | Components | | | | | | | | | |
|---|---|---|---|---|---|---|---|---|---|---|
| | a | b | c | d | e | f | g | h | i | j |
| A1 | 10 | 15 | 40 | 5 | 15 | | | | | 15 |
| A2 | 8 | 15 | 42 | | 15 | | | | | 20 |
| A3 | 11 | 15 | 39 | | 15 | | | 20 | | |
| A4 | 10 | 15 | 40 | | 15 | | | 20 | | |
| A5 | 10 | 15 | 35 | | 20 | | | | 20 | |
| A6 | 8 | 15 | 42 | | 15 | | | | 20 | |
| A7 | 9 | 15 | 25 | 5 | 26 | | | | | 20 |
| A8 | 10 | 15 | 27 | 13 | 15 | | | 20 | | |
| A9 | 8 | 15 | 32 | | 15 | | | 30 | | |
| A10 | 11 | 15 | 39 | | 15 | | | 20 | | |
| CA1 | 10 | | 35 | 20 | 35 | | | | | |
| CA2 | 10 | 15 | 30 | 30 | 15 | | | | | |
| CA3 | 10 | | 35 | | 30 | | | 25 | | |
| CA4 | 8 | 15 | 32 | 10 | 15 | | 20 | | | |

a: methacrylic acid
b: p-isopropenylphenol
c: isobornyl acrylate
d: n-butyl acrylate
e: tricyclo(5.2.1.0$^{2,6}$)decanyl methacrylate
f: methoxytriethylene glycol acrylate
g: ethoxydiethylene glycol acrylate
h: phenoxydiethylene glycol acrylate
i: lauroxytetraethylene glycol acrylate
j: phenoxytripropylene glycol acrylate

[Example 1]

<Preparation of resin composition>

The polymer A1 (100 g); ARONIX M-8100 (60 g) and ARONIX M-320 (10 g) (manufactured by Toagosei Co., Ltd.) as the ethylenically unsaturated compounds (B);
2,2'-bis(2-chlorophenyl)-4,5,4',5'-tetraphenyl-1,2'-biimid azole (4 g),
2-methyl-1-[4-(methylthio)phenyl]-2-morpholinopropanone-1 (10 g) and 4,4'-bis(diethylamino)benzophenone (0.2 g) as the radiation-sensitive radical polymerization initiators (C); FTX-218 (0. 3 g) (manufactured by NEOS) as surfactant; and ethyl lactate (150 g) as solvent were mixed together and were stirred to give a uniform solution. The solution was filtered through a 10-μm capsule filter. Consequently, a radiation-sensitive resin composition was prepared.

[Examples 2-11 and Comparative Examples 1-4]

<Preparation of resin compositions>

Radiation-sensitive resin compositions were prepared in the same manner as in Example 1, except that the types and amounts of the components were altered as shown in Table 2.

[Example 12]

<Preparation of resin composition>

A radiation-sensitive resin composition was prepared in the same manner as in Example 1, except that the polymer was replaced by the polymer A10 (100g) and the solvent was replaced by PGMEA (150 g).

Table 2

| | Polymer (parts) | | Ethylenically unsaturated compound (parts) | | | | Radical polymerization initiator (parts) | | | | | |
|---|---|---|---|---|---|---|---|---|---|---|---|---|
| | | | B1 | B2 | B3 | B4 | C1 | C2 | C3 | C4 | C5 | C6 |
| Ex. 1 | A1 | 100 | 60 | 10 | | | | | 4 | 10 | 0.2 | |
| Ex. 2 | A2 | 100 | 60 | 10 | | | | | | 10 | 0.2 | 4 |
| Ex. 3 | A2 | 100 | 60 | 10 | | | | | 4 | 10 | 0.2 | |
| Ex. 4 | A3 | 100 | 60 | 10 | | | | | 4 | 10 | 0.2 | |
| Ex. 5 | A3 | 100 | 60 | 10 | | | | | | 10 | 0.2 | 4 |
| Ex. 6 | A4 | 100 | 60 | 10 | | | 10 | 5 | 4 | | | |
| Ex. 7 | A5 | 100 | 60 | 10 | | | | | 4 | 10 | 0.2 | |
| Ex. 8 | A6 | 100 | 60 | 10 | | | | | 4 | 10 | 0.2 | |
| Ex. 9 | A7 | 100 | 60 | 10 | | | | | 4 | 10 | 0.2 | |
| Ex. 10 | A8 | 100 | | | 10 | 45 | | | 4 | 10 | 0.2 | |
| Ex. 11 | A9 | 100 | | | 10 | 45 | | | 4 | 10 | 0.2 | |
| Ex. 12 | A10 | 100 | 60 | 10 | | | | | 4 | 10 | 0.2 | |
| Comp. Ex. 1 | CA1 | 100 | 60 | 10 | | | 10 | 5 | 4 | | | |
| Comp. Ex. 2 | CA2 | 100 | 60 | 10 | | | | | 4 | 10 | 0.2 | |
| Comp. Ex. 3 | CA3 | 100 | 60 | 10 | | | 10 | 5 | 4 | | | |

(continued)

| | Polymer (parts) | | Ethylenically unsaturated compound (parts) | | | | Radical polymerization initiator (parts) | | | | | |
|---|---|---|---|---|---|---|---|---|---|---|---|---|
| | | | B1 | B2 | B3 | B4 | C1 | C2 | C3 | C4 | C5 | C6 |
| Comp. Ex. 4 | CA4 | 100 | 60 | 10 | | | | | 4 | 10 | 0.2 | |

B1: ARONIX M-8100 manufactured by Toagosei Co., Ltd.
B2: ARONIX M-320 manufactured by Toagosei Co., Ltd.
B3: ARONIX M-315 manufactured by Toagosei Co., Ltd.
B4: ARONIX M-8060 manufactured by Toagosei Co., Ltd.
C1: 2,2-dimethoxy-1,2-diphenylethane-1-one
C2: 2-benzyl-2-dimethylamino-1-(4-morpholinophenyl)-butanone-1
C3: 2,2'-bis(2-chlorophenyl)-4,5,4',5'-tetraphenyl-1,2'-biimidazole
C4: 2-methyl-1-[4-(methylthio)phenyl]-2-morpholinopropanone-1
C5: 4,4'-bis(diethylamino)benzophenone
C6: 2,2'-bis(2,4-dichlorophenyl)-4,5,4',5'-tetraphenyl-1,2'-biimidazole

The radiation-sensitive resin compositions prepared in Examples 1-12 and Comparative Examples 1-4 were formed into resist films, the resist films were patterned, and platings were produced as described below. The properties of the radiation-sensitive resin films and cured films were evaluated. The results are shown in Table 3.

<Formation of pattern>

The resin composition was applied to a gold-sputtered substrate using a spin coater, and the coating was dried on a hot plate at 110°C for 5 minutes to form a resin film 25 μm in thickness. The film was irradiated with ultraviolet light from an ultrahigh-pressure mercury lamp (HBO manufactured by OSRAM, output: 1,000 W) at a dose of 300 to 1000 $mJ/cm^2$ through a pattern mask. The dose was read with an illuminometer (UV-M10 manufactured by ORC MANUFACTURING CO., LTD.) connected with probe UV-42 (photoreceiver). The latent image was developed with a 2.38% by weight aqueous tetramethylammonium hydroxide solution at room temperature, followed by washing with running water and nitrogen blowing to produce a resist pattern. This substrate with the resist pattern will be referred to as the "patterned substrate".

<Formation of platings>

Prior to electroplating, the patterned substrate was pretreated by oxygen plasma ashing (output: 100 W, oxygen flow: 100 ml, treatment time: 1 minute) to make the surface hydrophilic. The substrate was electroplated with copper at 60°C and 0.5 $A/dm^2$ for 50 minutes or 75 minutes. The plating solution was TEMPERESIST EX (manufactured by JAPAN PURE CHEMICAL CO., LTD.). Consequently, bumps with a height of 15 μm were produced. The resin film was released by being soaked in releasing solution THB-S2 (manufactured by JSR Corporation) at 50°C for 10 minutes with stirring, and the substrate with the platings resulted. This substrate with the platings will be referred to as the "plated substrate".

<Evaluation of resolution>

The patterned substrate was observed with a scanning electron microscope at a magnification of 1000 times to evaluate the resolution based on the following criteria.
AA: A pattern of 50 μm x 50 μm square protrusions as designed by the mask was formed without any undesired residual resist, and the sidewalls of the protrusions had an angle of 85 to 95° relative to the substrate.
CC: The above results were not obtained.

<Evaluation of adhesion>

The cross section of the patterned substrate was observed with a scanning electron microscope at a magnification of 1500 times to evaluate the adhesion based on the following criteria.
AA: The resist protrusions in the central area and at the edge of the wafer were not lifted.
CC: The resist protrusions in the central area and at the edge of the wafer were lifted or released.

<Evaluation of wettability with plating solution>

The wettability with the plating solution was evaluated by observing the plated substrate with an optical microscope at a magnification of 10 times. The evaluation was based on whether the patterned substrate soaked in the plating solution showed affinity for the plating solution and was plated without failure while bubbles surrounded by the resist protrusions were completely removed from the surface. The evaluation criteria were as follows.

AA: Plating failure occurred at a rate of 0 to less than 5% in the pattern.

BB: Plating failure occurred at a rate of 5 to 30% in the pattern.

CC: Plating failure occurred at a rate of more than 30% in the pattern.

<Evaluation of resistance to plating solution>

The patterned substrate was soaked in the plating solution to form bumps, and the plated substrate was washed with running water and was dried by blowing nitrogen gas. The resin film was not released from the substrate. The substrate surface was observed with an optical microscope to evaluate the resistance to the plating solution based on the following criteria.

AA: The resist protrusions in the central area and at the edge of the substrate were not lifted.

CC: The resist protrusions in the central area and at the edge of the substrate were lifted or released.

In this test of the plating solution resistance, the patterned substrate was soaked in the plating solution for 50 minutes and 75 minutes.

<Evaluation of releasability>

The cured resist film was released from the plated substrate, and the plated substrate was observed with a scanning electron microscope at a magnification of 1500 times. The releasability was evaluated based on the following criteria.

AA: No residual resist was observed.

CC: A residual resist was observed.

The results are shown in Table 3.

Table 3

| | Resolution (pattern configuration) | Adhesion | Wettability with plating solution | Resistance to plating solution | | Releasability |
|---|---|---|---|---|---|---|
| | | | | 50 minutes | 75 minutes | |
| Ex. 1 | AA | AA | AA | AA | AA | AA |
| Ex. 2 | AA | AA | AA | AA | AA | AA |
| Ex. 3 | AA | AA | AA | AA | AA | AA |
| Ex. 4 | AA | AA | AA | AA | AA | AA |
| Ex. 5 | AA | AA | AA | AA | AA | AA |
| Ex. 6 | AA | AA | AA | AA | AA | AA |
| Ex. 7 | AA | AA | AA | AA | AA | AA |
| Ex. 8 | AA | AA | AA | AA | AA | AA |
| Ex. 9 | AA | AA | AA | AA | AA | AA |
| Ex. 10 | AA | AA | AA | AA | AA | AA |
| Ex. 11 | AA | AA | AA | AA | AA | AA |
| Ex. 12 | AA | AA | AA | AA | AA | AA |
| Comp. Ex. 1 | AA | AA | AA | CC | CC | AA |
| Comp. Ex. 2 | AA | AA | AA | CC | CC | AA |
| Comp. Ex. 3 | AA | AA | AA | AA | CC | AA |
| Comp. Ex. 4 | AA | AA | AA | AA | CC | AA |

A process is provided whereby thick platings such as bumps and wirings are produced with high precision while a resist shows high swelling resistance to a plating solution and the plating solution is prevented from leaking in between the pattern and substrate. A radiation-sensitive negative resin composition shows high sensitivity in the production process and possesses excellent resolution and heat resistance. A transfer film includes the composition.

The radiation-sensitive negative resin composition includes (A) a polymer including a structural unit represented by Formula (1) and a structural unit represented by Formula (2); (B) a compound having at least one ethylenically unsaturated double bond; and (C) a radiation-sensitive radical polymerization initiator represented by Formula (3);

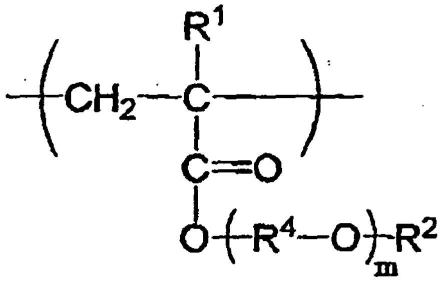

(1)

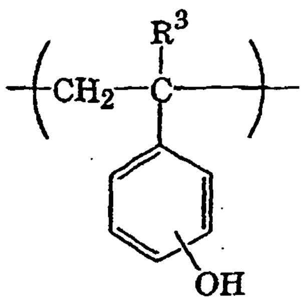

(2)

wherein $R^1$ is a hydrogen atom or a methyl group; $R^2$ is a linear, cyclic or aromatic hydrocarbon group of 6 to 12 carbon atoms, or a substituted hydrocarbon group wherein at least one hydrogen atom in the linear, cyclic or aromatic hydrocarbon group is substituted with a hydrocarbon group; $R^3$ is a hydrogen atom or a methyl group; $R^4$ is $-(C_nH_{2n})-$; m is an integer of 1 to 10; and n is an integer of 2 to 4.

## Claims

1. A radiation-sensitive negative resin composition, wherein the composition comprises:

(A) a polymer including a structural unit represented by Formula (1) and a structural unit represented by Formula (2);
(B) a compound having at least one ethylenically unsaturated double bond; and
(C) a radiation-sensitive radical polymerization initiator;

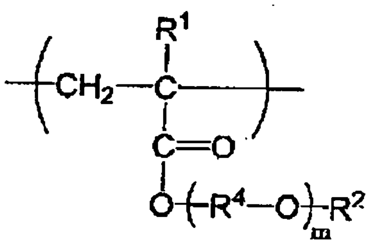

(1)

wherein $R^1$ is a hydrogen atom or a methyl group; $R^2$ is a linear, cyclic or aromatic hydrocarbon group of 6 to 12 carbon atoms, or a substituted hydrocarbon group wherein at least one hydrogen atom in the linear, cyclic

or aromatic hydrocarbon group is substituted with a hydrocarbon group; $R^4$ is $-(C_nH_{2n})-$; m is an integer of 1 to 10; and n is an integer of 2 to 4;

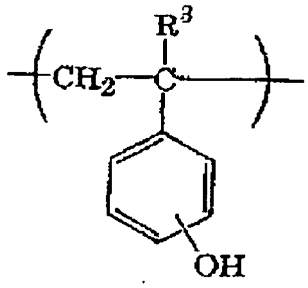

(2)

wherein $R^3$ is a hydrogen atom or a methyl group; and wherein the radiation-sensitive radical polymerization initiator (C) includes a biimidazole compound represented by Formula (3):

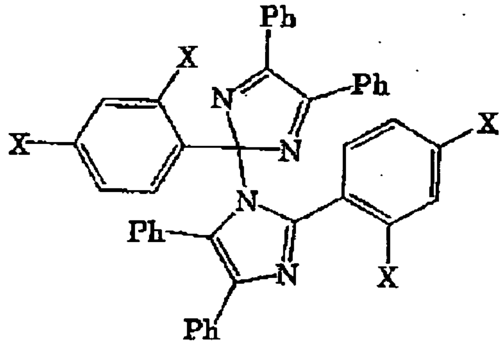

(3)

wherein X are each individually a hydrogen atom, a methyl group or a chlorine atom; and Ph is a phenyl group.

**2.** The radiation-sensitive negative resin composition according to claim 1, wherein the composition contains the compound (B) in an amount of 30 to 80 parts by weight based on 100 parts by weight of the polymer (A).

**3.** The radiation-sensitive negative resin composition according to claims 1 or 2, wherein the composition contains the radiation-sensitive radical polymerization initiator (C) in an amount of 1 to 40 parts by weight based on 100 parts by weight of the polymer (A).

**4.** The radiation-sensitive negative resin composition according to any one of claims 1 to 3, wherein the composition includes an organic solvent (D).

**5.** A plating produced by using the radiation-sensitive negative resin composition according to any one of claims 1 to 4.

**6.** A transfer film comprising a support film and a resin film on the support film, the resin film comprising the radiation-sensitive negative resin composition of any one of claims 1 to 4.

**7.** A process for producing platings, comprising the steps of:

(1) providing a resin film on a wafer having a barrier metal layer, the resin film comprising the radiation-sensitive negative resin composition of any one of claims 1 to 4;
(2) exposing the resin film to light and developing a latent image to form a pattern;
(3) depositing an electrode material by electroplating using the pattern as a template; and
(4) releasing the remaining resin film and etching the barrier metal layer.

## Patentansprüche

**1.** Strahlungsempfindliche Negativharzzusammensetzung, wobei die Zusammensetzung umfasst:

(A) ein Polymer, das eine strukturelle Einheit, die durch Formel (1) dargestellt ist, und eine strukturelle Einheit, die durch Formel (2) dargestellt ist, beinhaltet;
(B) eine Verbindung mit zumindest einer ethylenisch ungesättigten Doppelbindung; und
(C) einen strahlungsempfindlichen radikalischen Polymerisationsinitiator;

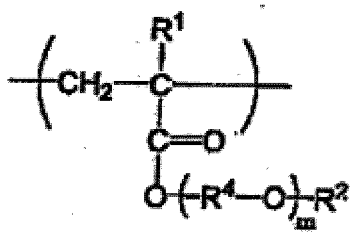

(1)

wobei $R^1$ ein Wasserstoffatom oder eine Methylgruppe ist; $R^2$ eine lineare, zyklische oder aromatische Kohlenwasserstoffgruppe mit 6 bis 12 Kohlenstoffatomen ist oder eine substituierte Kohlenwasserstoffgruppe, wobei zumindest ein Wasserstoffatom in der linearen, zyklischen oder aromatischen Kohlenwasserstoffgruppe mit einer Kohlenwasserstoffgruppe substituiert ist; $R^4$ $-(C_nH_{2n})-$ ist; m eine ganze Zahl von 1 bis 10 ist; und n eine ganze Zahl von 2 bis 4 ist;

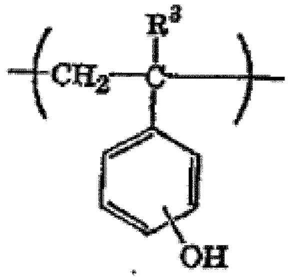

(2)

wobei $R^3$ ein Wasserstoffatom oder eine Methylgruppe ist; und wobei der strahlungsempfindliche radikalische Polymerisationsinitiator (C) eine Biimidazolverbindung, die durch Formel (3) dargestellt ist, beinhaltet:

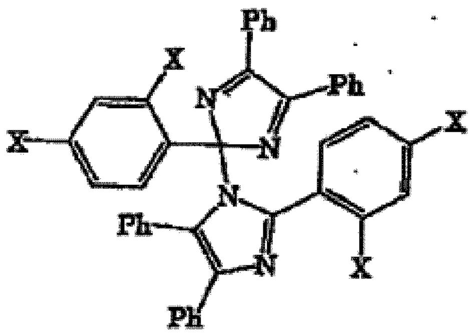

(3)

wobei X jeweils unabhängig ein Wasserstoffatom, eine Methylgruppe oder ein Chloratom sind; und Ph eine Phenylgruppe ist.

2. Strahlungsempfindliche Negativharzzusammensetzung nach Anspruch 1, wobei die Zusammensetzung die Verbindung (B) in einer Menge von 30 bis 80 Gewichtsteilen basierend auf 100 Gewichtsteilen des Polymers (A) enthält.

3. Strahlungsempfindliche Negativharzzusammensetzung nach Ansprüchen 1 oder 2, wobei die Zusammensetzung den strahlungsempfindlichen radikalischen Polymerisationsinitiator (C) in einer Menge von 1 bis 40 Gewichtsteilen basierend auf 100 Gewichtsteilen des Polymers (A) enthält.

4. Strahlungsempfindliche Negativharzzusammensetzung nach einem der Ansprüche 1 bis 3, wobei die Zusammensetzung ein organisches Lösungsmittel (D) beinhaltet.

5. Plattierung, die unter Verwendung der strahlungsempfindlichen Negativharzzusammensetzung nach einem der Ansprüche 1 bis 4 hergestellt ist.

6. Transferfilm, der einen Trägerfilm und einen Harzfilm auf dem Trägerfilm umfasst, wobei der Harzfilm die strahlungsempfindliche Negativharzzusammensetzung nach einem der Ansprüche 1 bis 4 umfasst.

7. Verfahren zur Herstellung von Plattierungen, das die Schritte umfasst von:

(1) Bereitstellen eines Harzfilms auf einem Wafer mit einer Barrieremetallschicht, wobei der Harzfilm die strahlungsempfindliche Negativharzzusammensetzung nach einem der Ansprüche 1 bis 4 umfasst;
(2) Belichten des Harzfilms mit Licht und Entwickeln eines latenten Bildes, um ein Muster zu bilden;
(3) Ablagern eines Elektrodenmaterials durch Elektroplattieren unter Verwendung des Musters als ein Templat; und
(4) Freisetzen des verbliebenen Harzfilms und Ätzen der Barrieremetallschicht.

## Revendications

1. Composition de résine négative sensible à un rayonnement, dans laquelle la composition comprend :

(A) un polymère incluant une unité structurelle représentée par la Formule (1) et une unité structurelle représentée par la Formule (2) ;
(B) un composé ayant au moins une liaison double éthyléniquement insaturée ; et
(C) un initiateur de polymérisation radicalaire
sensible à un rayonnement ;

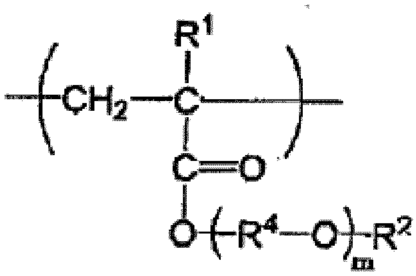

(1)

dans laquelle $R^1$ est un atome d'hydrogène ou un groupe méthyle ; $R^2$ est un groupe hydrocarbure linéaire, cyclique ou aromatique de 6 à 12 atomes de carbone, ou un groupe hydrocarbure substitué dans lequel au moins un atome d'hydrogène dans le groupe hydrocarbure linéaire, cyclique ou aromatique est substitué avec un groupe hydrocarbure ; $R^4$ est $-(C_nH_{2n})-$ ; m est un entier de 1 à 10 ; et n est un entier de 2 à 4 ;

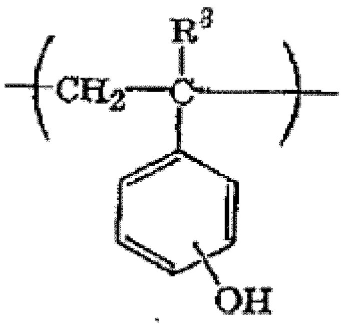

(2)

dans laquelle $R^3$ est un atome d'hydrogène ou un groupe méthyle ; et dans laquelle l'initiateur de polymérisation radicalaire sensible à un rayonnement (C) inclut un composé biimidazole représenté par la Formule (3) :

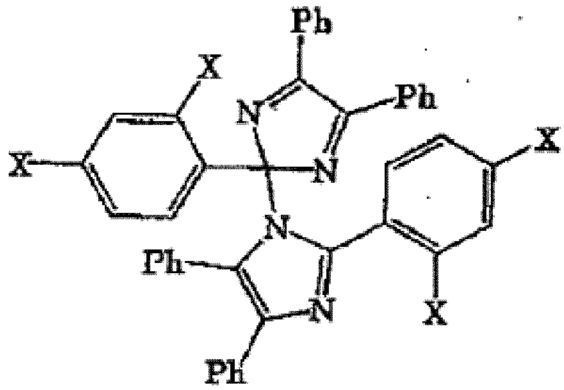

(3)

dans laquelle les X sont chacun individuellement un atome d'hydrogène, un groupe méthyle ou un atome de chlore ; et Ph est un groupe phényle.

**2.** Composition de résine négative sensible à un rayonnement selon la revendication 1, dans laquelle la composition contient le composé (B) dans une quantité de 30 à 80 parties en poids sur la base de 100 parties en poids du polymère (A).

**3.** Composition de résine négative sensible à un rayonnement selon la revendication 1 ou 2, dans laquelle la composition contient l'initiateur de polymérisation radicalaire sensible à un rayonnement (C) dans une quantité de 1 à 40 partie (s) en poids sur la base de 100 parties en poids du polymère (A).

**4.** Composition de résine négative sensible à un rayonnement selon l'une quelconque des revendications 1 à 3, dans laquelle la composition inclut un solvant organique (D).

**5.** Placage produit en utilisant la composition de résine négative sensible à un rayonnement selon l'une quelconque des revendications 1 à 4.

**6.** Film de transfert comprenant un film support et un film de résine sur le film support, le film de résine comprenant la composition de résine négative sensible à un rayonnement selon l'une quelconque des revendications 1 à 4.

**7.** Procédé de production de placages, comprenant les étapes de :

(1) prévision d'un film de résine sur une tranche ayant une couche métallique barrière, le film de résine comprenant la composition de résine négative sensible à un rayonnement selon l'une quelconque des revendications 1 à 4 ;
(2) exposition du film de résine à une lumière et révélation d'une image latente pour former un motif ;
(3) dépôt d'un matériau d'électrode par électroplacage en utilisant le motif comme un modèle ; et
(4) décollage du film de résine restant et gravure de la couche métallique barrière.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000039709 A
- JP H10161307 A
- JP H05341521 A
- EP 1610177 A1